# EUROPEAN PATENT APPLICATION

(11) **EP 4 614 579 A1**
(43) Date of publication of application: **10.09.2025**
(21) Application number: 24162056.6
(22) Date of filing: 07.03.2024
(51) Int. Cl.: H01L 33/62, H01L 33/48

(54) **PACKAGED LIGHT EMITTING SYSTEM**

(71) Applicant: Melexis Technologies NV, 3980 Tessenderlo-Ham (BE)
(72) Inventor: GRIMM, Heiko, 99099 Erfurt (DE)
(74) Representative: Bardehle Pagenberg Partnerschaft mbB Patentanwälte Rechtsanwälte

(57) **Abstract**

A light emitting device is provided, the light emitting device comprising a lead frame, a processing component connected to the lead frame, a terminal connected to the lead frame, an optical component, and an encapsulating material encapsulating the lead frame, the processing component, and the optical component at least partially. Further, a system comprising a corresponding light emitting device and a holder is provided, wherein the light emitting device is configured for being held by the holder.

## Description

### TECHNICAL FIELD

The current invention relates to light emitting systems. In particular, the current invention relates to a package comprising an optical component and a processing component that are encapsulated by an encapsulating material. A preferred application for the light emitting system according to the invention is automotive lighting, like interior vehicle lighting.

### BACKGROUND

While the invention is not limited to applications of interior vehicle lighting, several aspects of the underlying problem can be demonstrated easily for this type of application.

Generally, interior vehicle lighting offers three aspects of lighting, namely (i) general illumination (e.g. providing light for reading), (ii) design purposes (e.g. displaying of lighting to make the vehicle interior visually more appealing), and (iii) signaling of information (e.g. creating an optical warning to get the drivers attention). In order to enable these three aspects of lighting, generally a plurality of lighting devices is distributed throughout the vehicle interior - including lighting devices located at the top of the passenger cabin, lighting devices located on the center console, as well as lighting devices that trace the edges of functional elements (e.g. cabin pillars, doors) or design elements (e.g. interior decorations). Such lighting devices need to be small in size since the available space for lighting devices is rather limited in automotive applications.

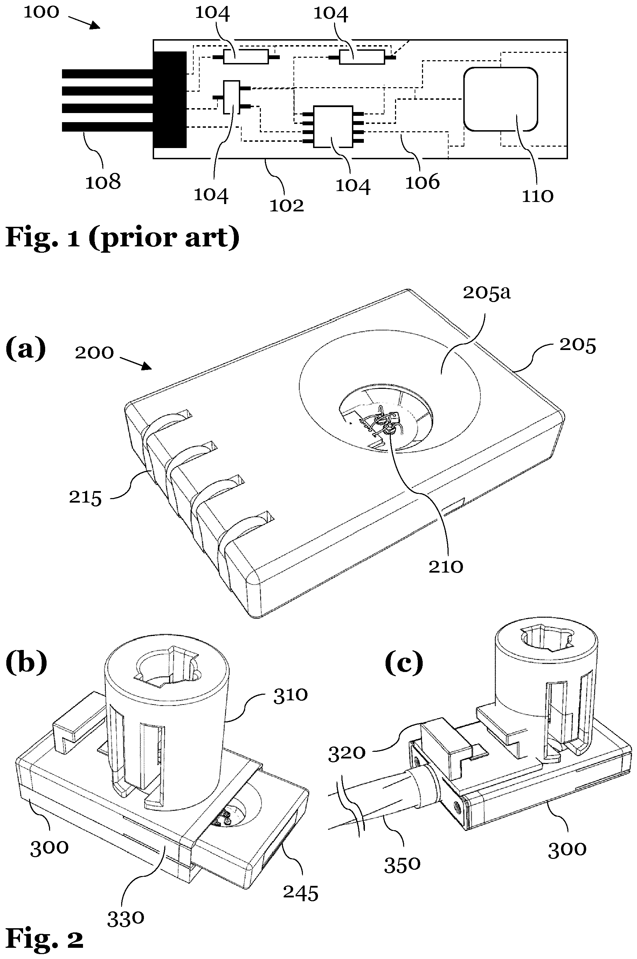

Lighting devices that are known in the art usually comprise an electronical component in form of a printed circuit board (PCB) with one or more light emitting diodes (LED) connected thereto and a holder in which the electronical component is placed. An example of such an electronical component according to the state of the art is depicted in figure 1. Generally, the electronical component 100 of figure 1 comprises a PCB 102, circuitry 104, connections 106 and an optical component 110.

However, miniaturization potential and reduction of costs are limited for these PCB-based components, which is why there is a need in the art for improved lighting devices that allow further degrees of miniaturization and improve cost-efficiency as well as reliability, for example by reducing the number of solder joints and interconnections between the components involved.

### SUMMARY

The invention is defined by the independent claims. Preferred embodiments are set out in the dependent claims. Wording such as "may" and "for example" used in the description in conjunction with features of the independent claims should not be interpreted to mean that those features are merely optional.

The abovementioned need is addressed by a light emitting device according to the invention. The light emitting device comprises a lead frame, a processing component, a terminal, an optical component, and an encapsulating material.

The lead frame may form a basis for the light emitting device, such that the processing component and other active or passive components, if any, can be placed on and connected to the lead frame. The optical component may be connected to the processing component and may be attached to the lead frame. Thereby, the optical component may either be placed directly on the lead frame or may at least partially be placed on top of another component that is connected to the lead frame, for example the processing component or one or more other active or passive components or other supporting components, if present. Active and passive components may include capacitors, resistors, diodes, among others. Supporting components in the sense of the current invention may, for example, include reflective elements that are arranged relative to the lead frame and the optical component or barriers that may be used to obstruct light paths.

The terminal, which may also be referred to as contact, is connected to the lead frame. For simplification, this specification only makes reference to a single terminal but the person skilled in the art will appreciate that more than one terminal may be present in any embodiment that falls within the scope of the current disclosure. Each terminal may have the same shape or some terminals may have different shapes. For example, the terminal may be a pin - either a straight pin or a curved pin (e.g. a J-shaped pin). However, other shapes may also be possible. While the terminal may be configured to be plugged into a suitable reception of another component (e.g. a socket), the terminal may additionally or alternatively have press-fit holes to increase the connection capabilities - e.g. the press-fit holes may be used to secure the terminal with a fastener that is inserted into the press-fit holes. In some embodiments, the terminals may also be used for soldering the light emitting device to a PCB.

The optical component may be configured to generate and emit light. Preferably, the optical component may emit light in the spectrum that is visible for the human eye (i.e. in the range of 400 nm to 800 nm), but in some embodiments the optical components may additionally or alternatively emit light outside of this spectrum, e.g. in the infrared or ultraviolet ranges. Depending on the desired application, some embodiments may emit light entirely outside of the spectrum that is visible to the human eye, e.g. infrared light or ultraviolet light. The skilled person will appreciate that the spectrum of the optical component may be selected in order to match the needs associated with a desired application without departing from the disclosure of the invention.

The encapsulating material encapsulates the lead frame, the processing component, and the optical component at least partially. Any additional component that is placed on the lead frame - e.g. the aforementioned active and passive components - may also be encapsulated by the encapsulating material. Encapsulating in the sense of the invention refers to the encapsulating material forming a package, which comprises at least portions of the lead frame, the processing component, the terminal and the optical component. The encapsulating material contacts the portions of the encapsulated components directly. This way, the encapsulating material provides protection of the components of the light emitting device. Some of the aforementioned components may be encapsulated entirely by the encapsulating material, while other components may not be encapsulated entirely. For example, the optical component should preferably not be encapsulated entirely by the encapsulating material in order to enable sufficient emission of light. Further, since the terminal is used to provide an electrical connection with another device, at least a portion of the terminal preferably should also not be encapsulated.

The encapsulating material may be a molding material. An example of the molding material may be an epoxy. Preferably, an area where the optical component is located is shaped as a cone-shaped cavity in order to improve the light output of the light emitting device, as will be explained in more detail in the detailed description of the figures. Bringing the encapsulating material in a preferred shape may be improved by using an encapsulating material that has at least some degree of stiffness. Hence, for these examples, a rather stiff encapsulating material, e.g. a silica epoxy, is preferred. Further, the encapsulating material may be opaque or non-transparent to a substantial degree in order to improve the protection capabilities (e.g. protection from ultraviolet light).

The encapsulating material may form an encapsulated package. This package may be realized by injection molding, a casting process (e.g. epoxy-based), by an additive manufacturing process (e.g. based on a 3D-printing process), or even by using a pre-molded package.

The abovementioned light emitting device according to the invention provides an improved light emitting device that enhances the miniaturization potential of light emitting devices by the combination of arranging the optical component and the processing component on a lead frame and encapsulating these components at least partially in an encapsulating material.

Furthermore, compared to PCB-based designs of light emitting devices, the disclosed encapsulation-based approach according to the invention improves cost efficiency and reliability. The encapsulation-based approach may in some examples also be referred to as molding-based approach.

In the following, preferred embodiments of the invention are disclosed. These preferred embodiments additionally improve certain aspects of the claimed teaching. All or single aspects of these preferred embodiments may be combined unless explicitly stated to the contrary.

In some embodiments, the light emitting device may be configured to be connectable to a light guide. A light guide may be a component that directs light from a light source - here the optical component of the light emitting device - to a place where the light is needed. The light emitted from the light emitting device may be directed into the light guide and guided by the light guide. For example, the light guide may define a path for directing the light emitted by the light emitting device. By ease of this specification, *"configured to be connectable to a light guide"* includes a direct connection or an indirect connection. In a direct connection of the optical component of the light emitting device and the light guide, the optical component and the light guide may be located directly adjacent, such that light emitted from the optical component directly enters the light guide. In an indirect connection, an area between the optical component of the light emitting device and the light guide may be filled with air, inert gas, or another - preferably transparent - material. The light guide itself may be made of a polycarbonate. Preferably, the light guide may have a refractive index in the range of 1.3 to 1.8, in some embodiments 1.5 to 1.6. The material of the light guide may include specialized low-refractive polymers or specialized high-refractive polymers. Also, coatings may be used to modulate the refractive index of the light guide material. Further, the skilled person will appreciate that the refractive index may be associated with the wavelength of the emitted light. In preferred embodiments, the abovementioned refractive indexes are associated with wavelengths in the range of approximately 400 nm to 800 nm.

The connection of the light emitting device with the light guide may be achieved by a reception for receiving the light guide. In some embodiments, the reception for receiving the light guide may be part of the light emitting device. In other embodiments, the reception for receiving the light guide may be part of a holder that is configured to arrange the light emitting device and the light guide relative to one another.

In some embodiments, the light emitting device may further comprise a photoactive element. The photoactive element may cover at least a portion of the optical component. For example, the optical component may comprise one or more light emitting elements (e.g. one or more light emitting diodes (LED)) and the photoactive element may cover at least one of these light emitting elements. In some examples, it may also be said that the photoactive element encapsulates at least one of the light emitting elements.

Further, the photoactive element may be configured to convert a wavelength of light emitted from the optical component. For example, it is known that artificial light sources, e.g. light emitting diodes (LED - may in some embodiments be referred to as LED chips), often create light with a spectrum that deviates from natural light, such as sunlight. The photoactive element is made of a photoactive material. For the means of this disclosure, the terms photoactive element and photoactive material are considered synonyms and are used interchangeably. Using a photoactive material may shift the wavelength of the light emitted by the optical component - or at least a portion of this wavelength - in a way that the spectrum of the emitted light more closely resembles the spectrum of natural light. In some cases, the shift may occur alongside a spread in the spectrum, meaning that while the light initially emitted by light source may form a narrow peak in the spectrum that is shifted and spread into a broader peak in the spectrum due to the influence of the photoactive material. For example, portions of the spectrum with smaller wavelengths, such as ultraviolet or blue light portions, may be converted to longer wavelengths, thereby increasing the amount of light emitted at longer wavelengths. In a non-limiting example, the optical component may comprise an LED made of indium gallium nitride (InGaN), which emits blue light. In this non-limiting example, the photoactive element may comprise a phosphorous coating comprising yttrium aluminum garnet (YAG) materials. In this case, the photoactive material can be excited by the blue light emitted from the InGaN-LED and perform a wavelength shift resulting in emission of yellow light. In this regard, it should be understood that the person skilled in the art will be familiar with the physical principle of this wavelength shift, which is therefore not explained in detail. Furthermore, the skilled person will be aware that other combinations of material of the photoactive material and the light source (e.g. LED) may achieve similar results. The combination of InGaN and phosphorous YAG materials is mentioned as non-limiting example to facilitate the understanding of the invention, but the disclosure is not limited to this particular example.

In some embodiments, the optical component may comprise one or more light emitting elements, wherein the one or more light emitting elements may be connected to the processing component. The connection may in some examples be a direct connection while in other examples, the connection may be an indirect connection, in which the one or more light emitting elements are connected to the processing component by one or more active or passive components, which may be arranged on the lead frame. Preferably, the one or more light emitting elements may be one or more single-color light emitting diodes (LED) or multi-color LEDs. The light emitting elements preferably emit light having a wavelength in a range that is visible to the human eye, for example in a range of approximately 400 nm to 800 nm.

One or more of the light emitting elements - e.g. LEDs - may be encapsulated by a photoactive material. In case that more than one light emitting element is present, multiple light emitting elements (may be referred to as a group of light emitting elements) may be encapsulated by the same volume of photoactive material or only a single light emitting element may be encapsulated by one volume of photoactive material. Noteworthy, the separated volumes of photoactive material may be of the same material or may be different materials. The separated volumes of photoactive material may be spatially separated, meaning that the volumes of photoactive material do not form a continuous amount of photoactive material. Additionally or alternatively, the volumes of photoactive material may be separated by protrusions, for example protrusions of the lead frame. Further, in some examples, two or more light emitting elements may be present and only a subset of the two or more light emitting elements may be encapsulated by a photoactive material.

In some embodiments, the optical component may comprise two or more light emitting elements and at least one barrier may be located between two adjacent ones of the two or more light emitting elements. It may also be said that the barrier separates the respective light emitting elements. In other words, the barrier may separate two areas, a first area comprising at least one of the two or more light emitting elements and a second area comprising at least another one of the two or more light emitting elements. In some embodiments, the barrier may be a portion of the lead frame, while in other embodiments the barrier may be a part of the optical component, for example an element that is added to the optical component, and may be attached to the lead frame by clueing, soldering or any suitable attachment process. The barrier may have a height and may represent an obstacle that prevents light emitted from the light emitting elements in the first area from reaching the light emitted elements in the second area (i.e. located on the other side of the barrier). It should be noted that the barrier may only represent an obstacle in the direct path between the light emitting elements, while light, which is emitted from a light emitting element in the first area and is reflected at another element (e.g. a surface of a filler material) may still reach a light emitting element located in the second area. Since the portion of reflected light is small compared to the overall amount of emitted light, this effect may be negligible.

In some embodiments, the barrier is provided in case that at least one light emitting element is encapsulated by a photoactive material as mentioned above. This way, the photoactive material will only be excited if the light emitting element that is encapsulated is operating (i.e. emitting light) and stray light emitted by one of the other light emitting elements will not excite the photoactive material - or at least only by a negligible amount. The skilled person will appreciate that this relative arrangement of light emitting elements encapsulated by photoactive material and a barrier is most efficient if each light emitting element (or group of light emitting elements) that is encapsulated by a photoactive material is separated from other light emitting elements by at least one barrier.

In some embodiments, the optical component may comprise a filler material. The filler material may be an epoxy, a silicone, a polycarbonate, or another type of polymer. Compared to the encapsulating material, which preferably is opaque or non-transparent to a substantial degree, the filler material may be transparent or translucent to at least some degree, wherein a higher degree of transparency improves the yield of light emitted from the light emitting device.

The filler material may provide manipulation of the light emitted at the optical component. For example, the filler material may provide refractive features. This may be achieved by at least a portion of the filler material forming an optical lens or an optical reflector. For example, an edge portion of the filler material, which is closest to the optical component, may have a shape that bends the emitted light. Such shapes may include simple convex and concave shapes, but also more complex shapes may be used. In some examples, this may be achieved by using different filler materials. This way, a boundary surface between the different filler materials may be configured in a preferred shape in order to manipulate the emitted light. This way, shapes may be defined, which form concave-convex, convex-concave, plano-concave, plano-convex, aspherical lenses, or even Fresnel lenses. The person skilled in the art will, however, appreciate that the mentioned examples of optical lenses are presented for illustrative purposes only and do not limit the scope of the invention. Instead, any lens shape may be used. Additionally or alternatively, different filler materials, which may have different refractive indices, may be used to manipulate the refraction of the emitted light.

Similarly, the edge portion of the filler material may form an optical reflector. The reflector may have any shape suitable for reflecting the emitted light, including a shape that reflects the light in way that the light reaches a light guide in a particular angle. The shapes may include the shape of a concave mirror or a section of a concave mirror. In some embodiments, the concave mirror may be a parabolic mirror or a section of a parabolic mirror. The person skilled in the art will, however, appreciate that the mentioned examples of optical reflectors are presented for illustrative purposes only and do not limit the scope of the invention. Instead, any reflector shape may be used.

Furthermore, the filler material may provide manipulation of light by ease of reflection and diffraction. This way, the filler material - or portions of the filler material - may be configured to provide interfaces at which the light emitted by the optical component is reflected and/or diffracted. This may be achieved by providing filler material in a particular shape or using different filler materials and creating boundary surfaces. To provide reflective and/or diffractive manipulation of light, reflective particles may be added to the filler material, including silicon dioxide (SiO₂), aluminum(III) oxide (Al₂O₃) or metal particles, e.g. silver (Ag).

Additionally or alternatively, the filler material may provide manipulation of light by ease of dispersion. This way, portions of the light emitted by the optical component may be dispersed and thereby separated in its spectral components. In some embodiments, the filler material may comprise one or more edge portions that are configured to enable partial or total reflection of light generated at the one or more light emitting elements. The edge portion may define a transition from the filler material to a component of the light emitting device that is adjacent to the optical component, for example the encapsulating material. Partial or total reflection may be achieved by adding a layer to the edge portion of the filler material. Based on the properties of the layer, partial reflection or total reflection may occur. For example, a reflective layer may be added to achieve partial reflection. Alternatively, the refraction indexes of the filler material and the layer may be chosen in a manner that total reflection occurs at the interface between the filler material and the layer. The skilled person will appreciate that total reflection may occur in case of light propagation from a material having a higher refractive index to a material having a lower refractive index - this means that total reflection may occur if the refractive index of the filler material is higher than the refractive index of the layer.

Creating total reflection at the edge portion increases the yield of the optical component, as the light generated at the optical component does not dissipate into the surroundings, e.g. the encapsulating material. Besides increasing the yield, partial reflection or total reflection has the advantage that durability of the light emitting device is increased. Due to the reflection, the amount of light that enters the encapsulating material is substantially reduced or even eliminated entirely and aging of the encapsulating material is reduced. This is of particular importance in case that the optical component generates emitted light at least partially in the lower wavelength spectrum (e.g. the blue to ultraviolet spectrum). Since the amount of light that enters the encapsulating material is substantially reduced or eliminated, materials that are adversely affected by light or which would adsorb substantial amounts of light (e.g. black materials) can be used as encapsulating materials, thereby increasing the available options of suitable materials for the encapsulating material.

Further, the light emitting device may comprise one or more wire bonds. Wire bonds may connect the one or more light emitting elements to the processing component and optionally to the lead frame, thereby enabling an electrical connection and enabling the processing component to control the light emitting elements. The one or more wire bonds may be located within the filler material of the optical component. Preferably, the wire bonds may be located entirely within the filler material and do not cross into another material, e.g. the encapsulating material. Since some of the components - e.g. the light emitting elements or the processing component - may generate heat during operation, the wire bonds would be prone to shear forces, if they crossed a border formed between the filler material and the encapsulating material. Hence, shear forces are avoided when the wire bonds do not cross the boundary of the filler material. In a similar manner, further wire bonds may be provided, which may enable connections between the processing component, the lead frame, the terminal, or other active or passive components that may be located on the lead frame. For similar reasons of reduced wear, said wire bonds preferably are entirely located within the encapsulating material that encapsulates the respective components.

In some embodiments, some connections between the one or more light emitting elements, the processing component and optionally the lead frame may be configured as bond pads. Bond pads may be used to provide connection points for wire bonds or for direct connections with components. For example, when wire bonds are used, the wire bonds may be connected between a component on the lead frame and a bond pad. In other examples, wire bonds may be used to connect a component with the lead frame directly, i.e. without the involvement of a bond pad (this connection may be referred to as down-bond). For direct placement of a component on a bond pad (may be referred to as component bond), one or more bond pads may be added to the lead frame and a respective component may be placed onto the bond pad and connected to the lead frame via the bond pad. In order to improve the bond, the respective component may comprise a connector which is configured to interact with the bond pad. The way in which a respective one of the one or more light emitting element is attached to the lead frame may in some embodiments depend on the type of the light emitting element or wavelengths of the light emitted by the light emitting element - i.e. in some cases, direct placing of a light emitting element on a bond may be preferred, while in other cases, it may be preferred to attach the light emitting element to the lead frame directly and provide connection to other components (e.g. the processing component) via a wire bond.

In some embodiments, connections between the processing component, the optical component, the terminal and other active or passive components that may be located on the lead frame may be provided by configuring one or more of these elements as flip-chip and directly soldering them to the lead frame by solder bumps. Alternatively to soldering, a conductive glue may be used or sintering may be performed. In some cases, placing components on the lead frame in a flip-chip configuration may include a placement of the component on a bond pad as is described in the paragraph above.

In some embodiments, the lead frame may comprise a portion that is bent or curved. In particular if the lead frame is bent or curved in a region where the optical component is located, the bending or curving may increase the yield of the optical component. Due to the lead frame being made of metal (in some preferred embodiments, the lead frame may be made of copper, a copper alloy, or a iron-nickel alloy), the lead frame usually has a certain degree of reflectiveness. Bending or curving the lead frame allows to alter the angle, in which the light generated at the optical component may be reflected at the lead frame. Thereby, the angle may be selected in a way that reflected light is directed, for example into the direction of a light guide. Additionally or alternatively, the angle may be selected in a way that the reflected light will undergo partial or total reflection at edge portions of filler material of the optical component.

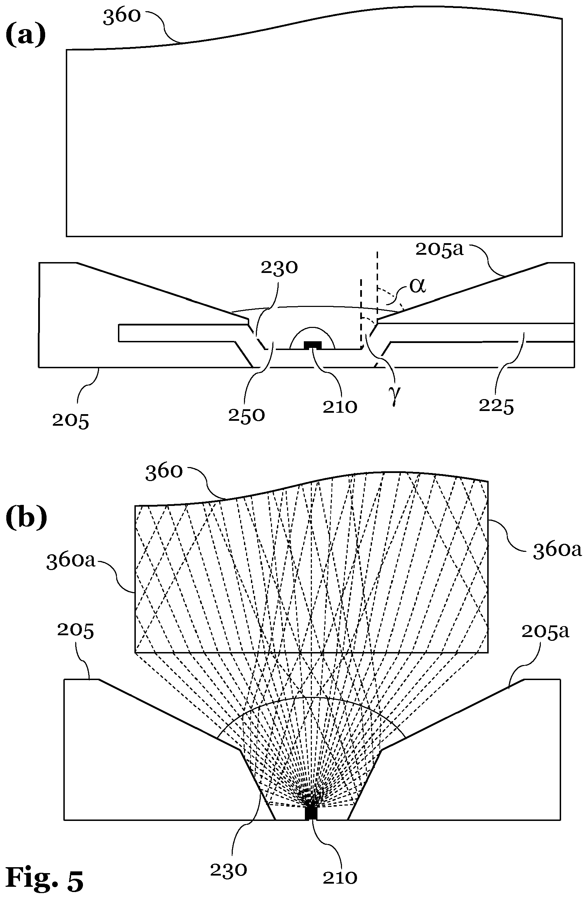

The bending or curving of the lead frame may comprise a curvature of the lead frame over a particular range. For example, a portion of the lead frame may be shaped similarly to a portion of a parabolic mirror. Alternatively, the lead frame may comprise a kink, which provides a sharp bending and is considered a bending/curving in the sense of this disclosure. In some preferred examples, the lead frame may be curved in an angle having a range of 10° to 80° (in some examples also up to almost 90°) relative to an orthogonal axis on the optical component of the light emitting device (see angle γ in figure 5). Particular angles of interest are from the set of {10°, 20°, 30°, 45°}. The angle may depend on the distance between the bending/curving and the optical component, the size of the optical component, the filler material (if any; in particular the refractive index of the filler material), or the light guide (if any; in particular the size of its opening or its refractive index).

The reflective properties of the lead frame may be enhanced by providing a galvanic or chemical finish with a low-corrosive and reliably solderable material to the surface of the lead frame. Examples of such materials may be nickel (Ni), palladium (Pd), or gold (Au).

In some embodiments, a portion of the lead frame may be at least partially located outside of the encapsulating material. Said portion may for example form a plate that is bent upwards or downwards from the lead frame. Due to a portion of the lead frame being located outside of the encapsulating material, said portion may be used to dissipate or conduct heat that is generated during operation of the light emitting device, e.g. from the optical component or the processing component. This way, the portion may form an interface to a heat sink with low thermal resistance. Said portion may be planar shaped or may be shaped in a way that increases its surface, for example by comprising a plurality of alternating protrusions and recesses. In some embodiments, the portion of the lead frame that is at least partially located outside of the encapsulating material may be located at the position of the optical component. Since the optical component may create a large amount of heat, this heat may be dissipated to a heat sink at said portion of the lead frame without the heat dissipating through substantial portions of the light emitting device.

Further, the portion that is at least partially located outside of the encapsulating material may comprise openings or stamped portions. These openings or stamped portions may be configured to receive a tool for placement in a holder. Depending on the encapsulating material that is used, the encapsulated package may be sensible during the assembly of the package to a holder. Providing a portion of the lead frame that extends beyond the encapsulating material allows to provide a portion that has suitable structural stability to reduce damage upon handling. Further, the openings or stamped portions may form a pattern that can be used for identification. This may allow to identify an encapsulated package even after it was placed in the holder. Moreover, the pattern may also be an indication of adequate positioning of the encapsulated package when it was placed in a holder. For example, the pattern may be used to identify cases in which the encapsulated package is placed upside down (e.g. with an output of the light emitting device pointing in the wrong direction). As such, the pattern may be used during assembly of the encapsulated package into a holder in order to avoid incorrect placement of the encapsulated package already during the assembly.

In some embodiments, the portion of the lead frame that is at least partially located outside of the encapsulating material may also function as terminal, while the terminal and said portion are different sections of the lead frame in some other embodiments.

In some embodiments, the processing component may be coated with a protective layer. Examples of suitable coatings include polyamide-based or polyimide-based coatings.

The abovementioned needs are also fulfilled by a system comprising a light emitting device and a holder. The light emitting device may be one of the abovementioned light emitting devices or a combination of the described devices. The light emitting device according to the system is configured for being held by the holder. The holder may comprise a reception that enables the holder to hold the light emitting device. The reception may for example encompass or receive at least a portion of the light emitting device.

In some embodiments, the holder or the light emitting device may comprise a reception for receiving a light guide. The light guide may define a path for directing light emitted by the light emitting device. In some embodiments, at least a portion of said path may define a non-zero angle relative to an orthogonal axis on the optical component of the light emitting device. In other words, the light guide directs the emitted light into a desired direction. The path may perform turns in order to direct the light into the desired direction.

In some embodiments, the system may comprise one or more interfaces. In some cases, the one or more interfaces may be configured to establish a connection between the light emitting device and the holder, while in other cases, at least one of the one or more interfaces may additionally or alternatively be configured to establish a connection between the light emitting device and surrounding environment (e.g. free air). For example, at least one of the one or more interfaces may be a thermal interface that is configured to enable heat transfer from the light emitting device, thereby acting as a heat sink. For example, the optical component may be connected via the lead frame to the holder in order to provide a heat sink to dissipate heat generated at the optical component to the holder. In some cases, the holder may be a plastic component and therefore may have limited thermal conductive abilities. Heat transfer may therefore be improved by providing a holder with a heat sink (e.g. a thermal conductive section that is configured to receive the heat from the thermal interface) or by configuring the thermal interface to reject or radiate heat to free air, which may be improved by increasing the surface of the thermal interface (e.g. by providing protrusions and recesses that increase the surface of the thermal interface). Similarly to the heat generated at the optical component, heat generated at the processing component may also be dissipated by a connection of the processing component, the lead frame and a thermal conductive interface. The processing component may be thermally connected to the optoelectronic components via the lead frame. The processing component may comprise an integrated temperature sensor that may enable the measuring of the temperature of the optoelectronic devices.

Additionally or alternatively, at least one of the one or more interfaces may be an electrical interface that establishes an electrical conductive connection between the holder and the terminal of the light emitting device. This may enable a control of the light emitting device.

### BRIEF DESCRIPTION OF THE DRAWINGS

The following description and the annexed figures set forth in detail certain illustrative aspects of the light emitting device described above. These aspects are indicative, however, of but a few of the various ways in which the principles of various embodiments can be employed and the described embodiments are intended to include all such aspects and their equivalent.

In the figures, like reference characters generally refer to the same parts throughout the different figures. The figures are not necessarily to scale. Instead, a general focus is put on an explanation of the universal principles of the invention.

In the following description, various embodiments of the invention are described with reference to the following figures:
- FIG. 1: shows a PCB-based light emitting device according to the state of the art;
- FIG. 2: shows a light emitting device and a system of a light emitting device and a holder according to the invention;
- FIG. 3: shows a light emitting device and a lead frame of a light emitting device according to the invention;
- FIG. 4: shows a light emitting device, a cross-section of the light emitting device, and a top view of a portion of the light emitting device according to the invention;
- FIG. 5: shows a cross-section of the lead frame and the optical component of a light emitting system according to the invention in combination with a light guide and illustrates refraction and reflection of the light emitted by the optical component;
- FIG. 6: shows several examples of light emitting devices according to the invention having different configurations of terminals;
- FIG. 7: shows an example of a holder according to the invention;
- FIG. 8: shows a light emitting device and a cross-section of the light emitting device according to the invention, wherein the optical component of the light emitting device comprises a light emitting element encapsulated by a photoactive material and wherein a barrier separates the encapsulated light emitting element from other non-encapsulated light emitting elements; and
- Fig. 9: shows several examples of holders used in combination with a light emitting device according to the invention.

### DETAILED DESCRIPTION

The following detailed description refers to the accompanying figures that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

Figure 1 shows a PCB-based electronic component according to the state of the art. The PCB-based electronic component is generally shown at 100. The PCB-based electronic component comprises a printed circuit board (PCB) 102 and a number of active or passive components 104 attached to the PCB 102. Further, PCB-based light emitting device 100 comprises a set of terminals 108 and an optical component 110. Connections 106 between the components 104, the terminal 108 and the optical component 110 are etched in the PCB 102.

Figure 2 shows a light emitting device and a system of a light emitting device and a holder according to the invention, wherein (a) shows the light emitting device in a perspective view, (b) shows the light emitting device being slid into a holder, and (c) shows said holder from a different view angle and with attached cable for electronic connection.

In figure 2 (a), the light emitting device according to the invention is generally shown at 200. The light emitting device 200 represents an encapsulated package. An encapsulating material 205 encapsulates a lead frame at least partially. The lead frame comprises one or more terminals 215, the terminals 215 having a portion that is not encapsulated by the encapsulating material 205 in order to enable a connection to another component. Further, since the encapsulating material encapsulates some of the components only partially, the encapsulating package comprises an opening. In figure 2, said opening is illustrated by ease of a cavity in form of a truncated cone 205a. Said cavity 205a is open at its bottom, where an optical component 210 that is attached to the lead frame of the light emitting device 200 is located. This configuration enables light emitted from the optical component 210 of the light emitting device 200 to be emitted from the encapsulated package. While the opening is illustrated in form a truncated cone 205a, the skilled person will appreciate that other shapes may also be possible and the invention is not limited to this particular shape.

In figure 2 (b), the light emitting device 200 according to the invention is held by a holder 300. While there are several ways of how the holder 300 may hold the light emitting device 200, figure 2 (b) illustrates an embodiment example in which the holder 300 accommodates the light emitting device 200 at least partially. This is achieved by the light emitting device 200 being at least partially slid into the holder 300. The holder 300 can generally be used to support the light emitting device 200 and may receive an electronical connection to a controller (e.g. by ease of a cable as illustrated in figure 2 (c)). Further, the holder 300 may provide a connection between the light emitting system 200 and a light guide.

In order to accommodate the light emitting device 200, the holder 300 comprises a cavity in which the light emitting device may be placed - for example by ease of a sliding motion as illustrated in figure 2 (b). It can be said that the cavity has a complementary form to the light emitting device 200, such that the light emitting device 200 tightly fits into the cavity of the holder 300. The holder 300 may also comprise one or more clamps 330, which secure the light emitting device 200 once it is placed into the holder 300. As the skilled person will appreciate, figure 2 (b) illustrates an intermediate state of the light emitting device 200 being partially slid into the cavity of the holder 300. The light emitting device 200 may be slid further into the cavity of the holder 300 until plate 245 of the light emitting device 200 is leveled with the free end of the clamp 330. The skilled person will appreciate that further options of placing the light emitting device (at least partially) into the holder are encompassed by the current invention. The option of sliding the light emitting device into a cavity in the holder is described a non-limiting example.

Generally, a reception for a light guide may be part of the light emitting device or the holder, wherein the reception is configured to receive at least a portion of a light guide in order to provide a path to guide the light emitted at the light emitting device. In the example illustrated in figure 2 (b), the holder 300 comprises a reception 310 for a light guide. When the light emitting device 200 is securely held within the holder 300 as described with reference to figure 2 (b) above, the reception 310 for a light guide is located such that an entry to the light guide will be held at a vicinity of the optical component 210 of the light emitting device 200, for example directly at the cavity formed by the truncated cone 205a of the light emitting device 200. A light guide may be plugged into the reception 310. In some embodiments, the connection between the light guide and the reception 310 may be detachable, whereas in other embodiments, the connection may be a permanent connection.

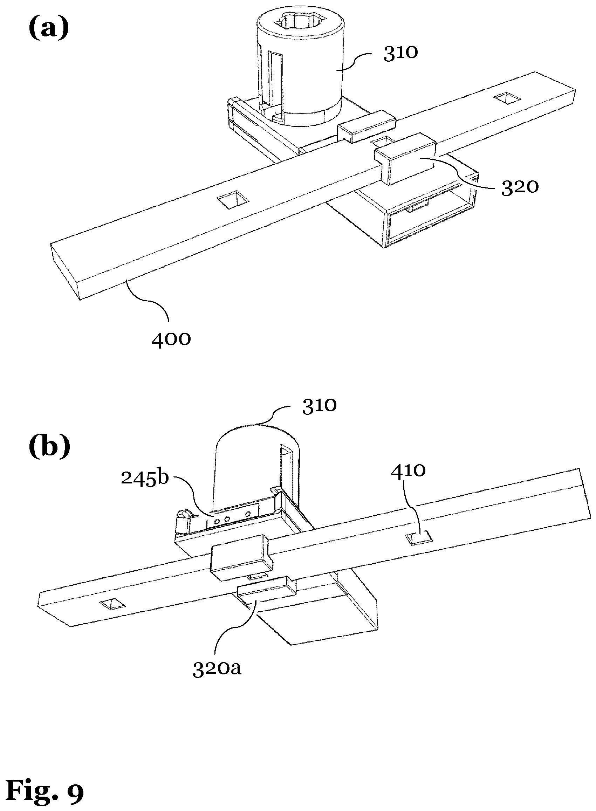

Further, the holder 300 may comprise a means for connecting to another structure. The other structure may for example be a portion of a frame that can be used to arrange the system of the light emitting device and the holder in a desired location, e.g. an interior of a vehicle. This is illustrated in more detail with respect to figure 9. In figure 2 (c), the means for connecting is formed by a clamp 320.

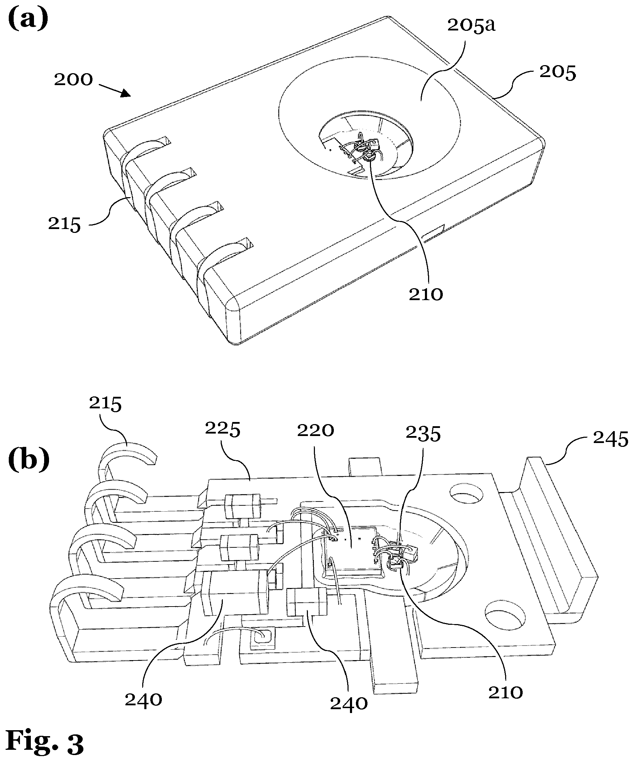

Figure 3 shows a light emitting device and a lead frame of a light emitting device according to the invention, wherein (a) is the same perspective view of the light emitting device 200 as illustrated in figure 2 (a), and (b) is a perspective view of a lead frame of a light emitting device according to the invention.

The lead frame 225 comprises active and passive components of the light emitting device 200 according to the invention, for example the one or more terminals 215, the processing circuit 220, the optical component 210, one or more additional active or passive components 240. Further, a portion of the lead frame 225 is formed as a plate 245 that may be bent upwards from the lead frame 225 as illustrated in figure 3 (b).

The lead frame 225 is generally configured to provide structural support to the active and passive components that are attached to it. This way, the lead frame 225 provides a basis for a precise relative arrangement of said components relative to one another, so that the encapsulated package of the light emitting system can be connected to a holder, such that the optical component is aligned with the reception for the light guide.

Further, the lead frame 225 can provide electronical connections between the active and passive components attached to it. Further connections may be provided by wire bonds 235.

The plate 245 of the lead frame 225 is preferably at least partially not encapsulated by encapsulating material 205 of the light emitting device 200, such that it may be used to dissipate or conduct heat. In figure 3 (b), the plate 245 is planar shaped, but it may be shaped in other ways in other embodiment examples, for example in a way that increases its surface, e.g. by comprising a plurality of alternating protrusions and recesses, in order to reject or radiate heat to surrounding air. In some other examples, the plate 245 may be configured to be connected to a heat sink.

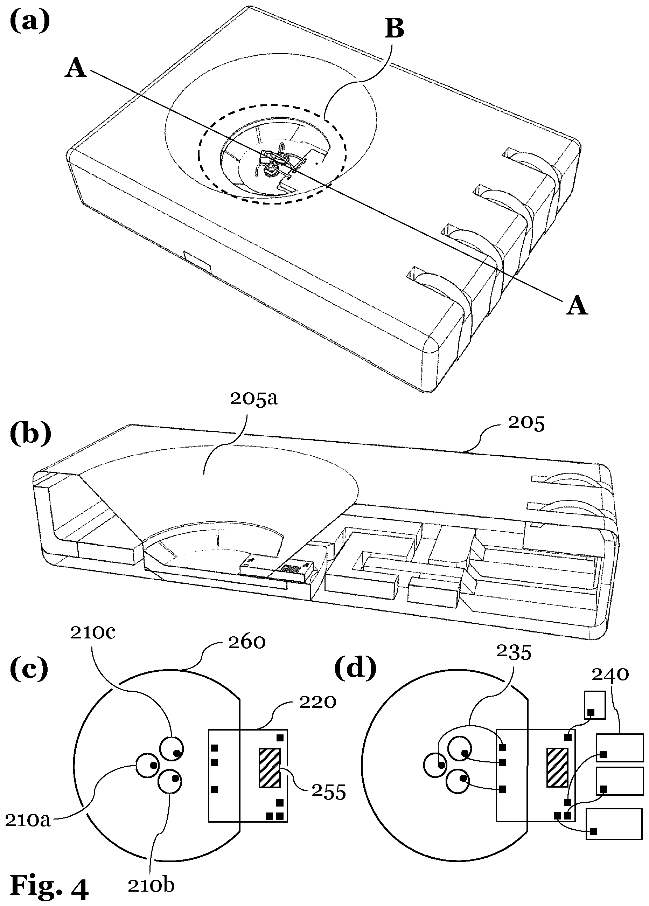

Figure 4 shows a light emitting device, a cross-section of the light emitting device, and a top view of a portion of the light emitting device according to the invention, wherein (a) is the perspective view of the light emitting device 200, (b) is a cross-sectional view along axis A-A in figure 4 (a), and (c), (d) are a top views of section B highlighted in figure 4 (a).

In the example illustrated in figure 4, the optical component is formed by three LED chips 210a, 210b, 210c. Each of these LED chips 210a, 210b, 210c may have a different emission spectrum - for example, the three LED chips may generate an RGB emission spectrum, for example one LED being a red (R) LED, one LED being a blue (B) LED, and one LED being a green (G) LED. In this regard, the skilled person will appreciate that the example illustrated in figure 4 does not limit the scope of the invention. In other embodiments, less than three LEDs - including a single LED - may be used, while in other embodiments more than three LEDs may be used, including, for example, four LEDs creating a RGBW spectrum (RGB plus warm white) or five LEDs creating a RGBWW spectrum. In some examples, one or more of the LEDs may be covered with a photoactive material. For example, an RGBWW spectrum may be achieved by using a red LED, a green LED, a blue LED, a white LED, and a blue LED covered with a photoactive material in order to generate emission of white light.

In the cross-section of the light emitting device 200 in figure 4 (b), the cavity formed by the opening in the encapsulating material 205 in shape of a truncated cone 205a. Further, some of the components attached to the lead frame (see figure 3 (b)) are depicted in order to illustrate how these components may be encapsulated by the encapsulating material 205.

Figures 4 (c), (d) illustrate the opening in the encapsulating material 205 in more detail in a top view of section B of figure 2 (a). The boundary 260 in figures 4 (c) and (d) represents the opening at the bottom of the truncated cone 205a in the encapsulating material 205. Elements, which are located within the boundary 260, are not encapsulated by the encapsulating material 205, whereas elements, which are located outside of the boundary 260, are encapsulated by the encapsulating material 205. In other words, elements, which are located within the boundary 260, can be seen from the outside, while elements, which are located outside the boundary 260, are covered by the encapsulating material 205 and cannot be seen from the outside (in case that the encapsulating material 205 is opaque to at least some degree, which is preferred).

In figures 4 (c) and (d), the optical components 210 and a portion of the processing component 220 are located within the boundary 260, whereas some active or passive components 240 and a remainder portion of the processing component 220 are located outside the boundary 260. Said remainder portion of the processing component 220 may comprise a memory portion 255. Such a configuration is particularly preferred in case that the processing component is a component with a non-volatile memory. Examples of components with non-volatile memory may be a so-called one-time-programmable (OTP) circuit, a flash memory, or an electrically erasable programmable read-only memory (EEPROM). Such non-volatile memories - in particular OTPs - have a risk to be erased when they are exposed to ultraviolet (UV) light. Since the portion located within the boundary 260 may be exposed to UV light - either from the outside (e.g. ambient light) or in case that at least a portion of the light emitted by the optical component is in the UV spectrum - locating the memory 255 of a component with a non-volatile memory in a portion of the processing circuit that is encapsulated by the (preferably opaque) encapsulating material 205 protects the non-volatile memory from being impacted by light within a critical wavelength range (e.g. ultraviolet light), which may include reduction of a data retention parameter of the non-volatile memory, reduced reliability, data loss or other causes of malfunction.

Since the light emitted from the optical component 210 may in some cases still impact the portion of the processing component 220 that is located within the boundary 260, the processing component 220 - either entirely or the portion that is located within the boundary 260 - may be coated with a protective layer. The protective layer may also be referred to as passivation layer. Forms of passivation layers may include ultraviolet transparent layers, for example made of silicon dioxide (SiO₂), or layers that are non-transparent to ultraviolet light (UV protection layer), for example made of silicon nitride (Si₃N₄) or a combination of silicon nitride (Si₃N₄) and silicon dioxide (SiO₂).

In addition to arrangement of the components in the top view of figure 4 (c), the top view of figure 4 (d) shows wire bonds 235 that are used to provide electronical connections. In the preferred embodiment that is illustrated in figure 4 (d), the wire bonds 235 do not pass through different materials. Instead, components that are located within the boundary 260 are connected via wire bonds 235 that entirely lie within the boundary - see connections between the optical component(s) 210 and the portion of the processing component 220 that is located within the boundary 260. Further, active and passive components 240 fully encapsulated by the encapsulating material (i.e. located outside of the boundary 260) may be connected with wire bonds to the remainder portion of the processing component 220 that is located outside of the boundary 260, i.e. also encapsulated by the encapsulating material. Since the processing component 220 and/or the optical component(s) 210 may generate heat during operation, the encapsulating material 205 may undergo heat deformation. In cases that wire bonds would pass through a boundary surface of the encapsulating material (e.g. a boundary surface of the encapsulating material abutting a filler material (see figure 5) or a boundary surface of the encapsulating material and adjacent air), the wire bonds would experience shear forces. This can be avoided by having each wire bond passing through only one kind of material.

Figure 5 shows a cross-section of the lead frame and the optical component of a light emitting system according to the invention in combination with a light guide and illustrates refraction and reflection of the light emitted by the optical component. In figure 5 (a), the structure of the light emitting system and an adjacent light guide are illustrated in detail, whereas figure 5 (b) illustrates light refraction and reflection of the light emitted by the optical component of the light emitting system.

Figure 5 (a) illustrates a cross-section of the light emitting system 200 having a lead frame 225 with an optical component 210. Further, the components of the light emitting system are at least partially encapsulated by a encapsulating material 205. In the depicted embodiment example, at the position where the optical component 210 is attached to the lead frame 225, a portion of the lead frame 225 is bent or curved. In figure 5, this is illustrated by ease of a bended portion 230 of the lead frame 225. The bended portion 230 is bend in an angle γ relative to an orthogonal axis on the optical component of the light emitting device, wherein said axis is illustrated as dashed line in figure 5 (a). The angle γ may have a range of 10 to 80 (in some examples also up to almost 90°). Particular angles of interest are from the set of {10°, 20°, 30°, 45°}. The angle may depend on the distance between the bending/curving and the optical component, the size of the optical component, the filler material (if any; in particular the refractive index of the filler material), the light guide (if any; in particular the size of its opening or its refractive index). Further, reflectiveness of the bended portion 230 of the lead frame 225 may be increased by adding a coating (e.g. a reflective coating) or polishing the lead frame prior to assembly. The reflective properties of the lead frame may be enhanced by providing a galvanic or chemical finish with a low-corrosive and reliably solderable material to the surface of the lead frame.

Further, the opening in the encapsulating material 205 is formed by a truncated cone 205a. The truncated cone has an angle α relative to an orthogonal axis on the optical component of the light emitting device. The angle α may have a value of preferably 60° to 90° degrees. Compared to the angle γ, the angle α preferably has a larger value, in order to avoid that light reflected at the bended portion 230 of the lead frame 225 will scatter or be absorbed at the truncated cone 205a, which could reduce the yield of the light emitting device.

The volume at the bottom of the truncated cone 205a may be filled with or covered by a filler material 250. The bottom of the truncated cone 205a, may also be referred to as lower part of the truncated cone 205a or the portion of the truncated cone 205a that is close to the light emitting elements. The filler material 250 may improve the optical characteristics of the light emitting device, for example by providing a lens, which bends the light emitted from the optical component 210 into the light guide 360. Oftentimes, light guides are configured to enable total reflection at its lateral boundaries relative to the axial direction of light propagation through the light guide. Since total reflection depends on the angle in which light enters the light guide, the filler material 250 may manipulate the emitted light in a manner that at least a majority of the emitted light enters the light guide in an angle that enables total reflection.

As is illustrated in figure 5 (a), the filler material 250 may not contact the optical component 210. This way, the emitted light will experience refraction at both boundary surfaces of the filler material 250. However, in other embodiment examples, the filler material 250 may directly contact the optical component 210.

In figure 5 (b), the structural features of the light emitting system are simplified in order to put emphasis on the refraction and reflection of light. Here, the refraction/reflection of the emitted light is illustrated by a plurality of dashed lines. These dashed lines experience refraction at the bended portion of the lead frame and the boundary surfaces of the filler material and the light guide.

As can be seen, the reflection of the light emitted from the optical component 210 at the bended portion 230 of the lead frame 225 affects the angle at which the light enters the light guide 360. Similarly, the refractive index and the shape of the filler material 250 affects the angle at which the light enters the light guide 360. Hence, the angles, shapes and materials can be configured to provide increased yield by securing that the emitted light enters the light guide 360 in an angle that fulfills the requirements for total reflection at the lateral boundaries 360a of the light guide 360.

Further, the filler material and the bended portion 230 of the lead frame 225 may be configured to enable total reflection of the light reflected at the bended portion 230. This may also be enhanced by adding a coating to the bended portion 230 of the lead frame 225 as was described above. Since the optical component 210 of the light emitting device emits light in various directions, the skilled person will appreciate that total reflection may not be achieved for the entirety of the emitted light, but may be achieved for at least a substantial portion of the emitted light beams. Achieving total reflection at the bended portion of the lead frame has the particular advantage that the heat increase of the lead frame due to absorption of light is reduced.

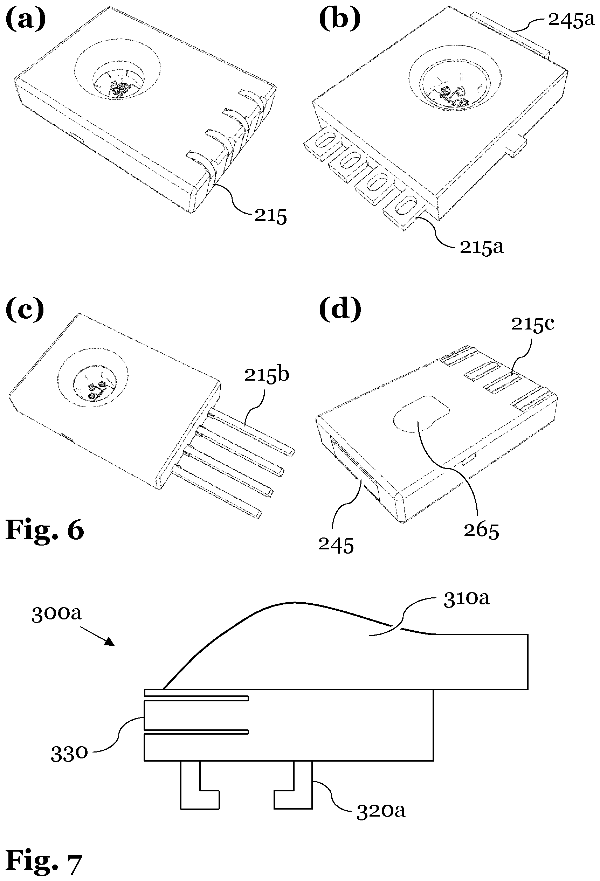

Figure 6 shows several examples of light emitting devices according to the invention having different configurations of terminals. The terminals 215 of figure 6 (a) correspond to the terminals 215 shown in figures 2, 3, and 4. These terminals have a so-called J-type configuration in which the wire of the terminal is biased similarly to a spring. When the terminal is slid into a suitable reception, the J-type pin will be slightly deformed and the biasing into the J-type shape improves the fit within the reception because the terminal's pin pushes against the contact plane in the reception.

The terminals 215a illustrated in figure 6 (b) comprise press-fit holes or holes for direct soldering of wires (e.g. soldering pins for through-hole assembly), which allows a fastener to reach through the holes in order to improve the fit. Further, the light emitting device illustrated in figure 6 (b) comprises a plate portion 245a, which forms a recess to the encapsulating material, thereby increasing the surface of the plate 245a that is available for heat dissipation.

The terminals 215b in figure 6 (c) are represented by pins that may be configured to be plugged into sockets or configured for through-hole PCB assembly. The terminals 215c in figure 6 (d) are represented by connector plates. Further, the plate 245 of the lead frame that can be used for heat dissipation is illustrated in this view angle on the device depicted in figure 6 (d).

Additionally, figure 6 (d) illustrates a form of a thermal interface 265. Compared to figures 6 (a) to (c), which illustrate the side of the light emitting device that comprises the opening through which the light may be emitted by the optical component (may be referred to as top side), figure 6 (d) illustrates the back side. In this view, the thermal interface 265, which may represent a portion of the lead frame that is not encapsulated by the encapsulating material, can be seen. The thermal interface 265 may be located at the same location as the optical component of the light emitting device, thereby allowing heat generated by the optical component to dissipate via the thermal interface 265. For example, when the light emitting device is placed in a holder, a heat sink may be connected to the thermal interface 265 to facilitate heat dissipation. This may be enhanced by a thermal conductive gel or paste that is applied to the thermal interface 265. A thermal conductive paste in this sense refers to a paste that contains filler particles that may enhance thermal conductivity.

Figure 7 shows an example of a holder according to the invention. The holder 300a illustrated in figure 7 is similar to the holder 300 illustrated in figures 2 (b) and (c). Compared to the holder 300, the clamp 320a of the holder 300a is located in a different position - here at the opposite side of the holder compared to the reception - and the reception 310a for receiving a light guide is configured to bend the light guide, thereby manipulating the path in which the light is emitted from the system. Compared to the holder 300 in which the reception extends in an orthogonal direction relative to the optical component of the light emitting device, the reception 310a turns the light guide by 90°. The skilled person will appreciate that the 90° turn represents an example and that other angles are also possible.

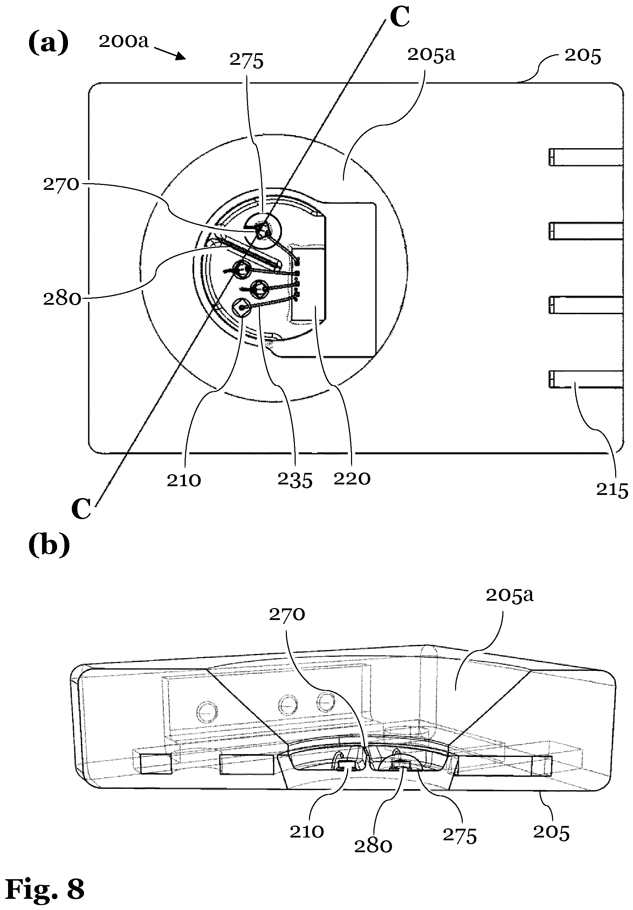

Figure 8 shows a light emitting device and a cross-section of the light emitting device according to the invention, wherein the optical component of the light emitting device comprises a light emitting element encapsulated by a photoactive material and wherein a barrier separates the encapsulated light emitting element from other non-encapsulated light emitting elements.

Figure 8 (a) illustrated a light emitting device 200a having an optical component made of four LED chips 210, 270. The three LED chips 210 illustrated in figure 8 (a) essentially correspond to the LED chips 210 illustrated in figure 3 and 4, whereas LED chip 270 is encapsulated by a photoactive material 275. Further, a barrier 280 is provided, which separates the three LED chips 210 from the LED chip 270 with the photoactive layer 275. Figure 8 (b) illustrates the embodiment examples illustrated in figure 8 (a) in a cross-section along line C-C of figure 8 (a).

Figure 9 shows several examples of holders used in combination with a light emitting device according to the invention.

The holders illustrated in figures 9 (a) and (b) comprise a means for connecting to another structure. In the illustrated case, the means for connecting is represented by clamps 320, 320a and the other structure is a support in form of a track 400. This way, the holders can be pushed over the track by ease of the clamps 320, 320a. The track 400 may have a number of openings or recesses 410. These openings or recesses 410 may represent locations at which a holder shall be placed and they may meshingly engage with a pin that extends from the holder at a location of a respective clamp 320, 320a, thereby locking the holder in a fixed position on the track 400.

Further, figure 9 (b) illustrates the plate of the lead frame that may be used for heat dissipation. In particular, openings 245b are shown that may be used for identification. This way, the pattern may indicate the type of device or may be used to verify accurate positioning of the device. For example, if the pattern is turned upside down, the device is also turned upside down and placed incorrectly in the holder, which results in a misalignment between the optical component and the reception 310 for the light guide.

What has been described above includes examples of one or more embodiments. It is, of course, not possible to describe every conceivable combination of components or methodologies for purposes of describing the aforementioned embodiments, but one of ordinary skill in the art may recognize that many further combinations and permutations of various embodiments are possible. Accordingly, the described embodiments are intended to embrace all such alterations, modifications and variations that fall within the spirit and scope of the appended claims.

## Claims

1. A light emitting device (200), comprising:
a lead frame (225);
a processing component (220) connected to the lead frame (225);
a terminal (215, 215a, 215b, 215c) connected to the lead frame (225);
an optical component (210); and
an encapsulating material (205) encapsulating the lead frame (225), the processing component (220), and the optical component (210) at least partially.

2. The light emitting device according to claim 1, further being configured to be connectable to a light guide (360).

3. The light emitting device according to any of the preceding claims, further comprising a photoactive element, which covers at least a portion of the optical component and which is configured to convert a wavelength of light emitted from the optical component.

4. The light emitting device according to any of the preceding claims, wherein the optical component (210) comprises one or more light emitting elements, wherein the one or more light emitting elements are connected to the processing component (220), wherein the one or more light emitting elements preferably are one or more single-color light emitting diodes, LEDs, or multi-color LEDs.

5. The light emitting device according to any of the preceding claims, wherein the optical component (210) comprises two or more light emitting elements and wherein at least one barrier is located between two adjacent ones of the two or more light emitting elements.

6. The light emitting device according to any of claims 4 and 5, wherein the optical component (210) comprises a filler material (250), preferably wherein at least a portion of the filler material (250) forms an optical lens or an optical reflector.

7. The light emitting device according to claim 6, further comprising one or more wire bonds (235) connecting the respective light emitting elements to the processing component (220); and
wherein said one or more wire bonds (235) are located within the filler material (250) of the optical component (210).

8. The light emitting device according to any of claims 6 and 7, wherein the filler material (250) comprises one or more edge portions that are configured to enable partial or total reflection of light generated at the one or more light emitting elements.

9. The light emitting device according to any of the preceding claims, wherein the lead frame (225) comprises a portion (230) that is bent or curved.

10. The light emitting device according to any of preceding claims, wherein a portion (245, 245a) of the lead frame (225) is at least partially located outside of the encapsulating material (205).

11. A system comprising:
a light emitting device (200) according to any of the preceding claims; and
a holder (300, 300a);
wherein the light emitting device (200) is configured for being held by the holder (300, 300a).

12. The system according to claim 11, wherein the holder (300, 300a) or the light emitting device comprises a reception (310, 310a) for receiving a light guide (360).

13. The system according to any of claims 11 and 12, further comprising one or more interfaces that establishes a connection between the light emitting device (200) and the holder (300, 300a).

14. The system according to claim 13, wherein at least one of the one or more interfaces is a thermal interface (245, 265) that is configured to enable heat transfer from the light emitting device (200).

15. The system according to any of claims 13 and 14, wherein at least one of the one or more interfaces is an electrical interface that establishes an electrical conductive connection between the holder (300, 300a) and the terminal (215, 215a, 215b, 215c) of the light emitting device (200).
